# EUROPÄISCHE PATENTSCHRIFT

(11) **EP 1 489 880 B1**
(45) Veröffentlichungstag und Bekanntmachung des Hinweises auf die Patenterteilung: **29.04.2009**
(21) Anmeldenummer: 03013421.7
(22) Anmeldetag: 20.06.2003
(51) Int. Cl.: H04R 3/04, H03G 5/16, H04H 20/00

(54) **Tonsignal-Bearbeitungsvorrichtung und Tonsignal-Bearbeitungsverfahren mit automatischer Klangspektrumauswahl**
Device and method for processing sound signals with automatic selection of acoustic spectrum
Dispositif et procédé de traitement des signaux sonores avec sélection automatique du spectre sonore

(43) Veröffentlichungstag der Anmeldung: 22.12.2004
(73) Patentinhaber: Harman Becker Automotive Systems GmbH, 76307 Karlsbad (DE)
(72) Erfinder: Zehnle, Guido, 76571 Gaggenau (DE); Günther, Ludwig, 76461 Muggensturm (DE)
(74) Vertreter: Bertsch, Florian Oliver

(56) Entgegenhaltungen:
- EP-A- 1 005 252
- DE-A- 4 141 843
- DE-A- 19 848 491
- US-A- 5 983 191

## Beschreibung

Die Erfindung bezieht sich auf eine Tonsignal-Bearbeitungsvorrichtung mit einer Klangspektrumauswahl für ein Tonsignal gemäß den oberbegrifflichen Merkmalen des Patentanspruchs 1 bzw. ein Tonsignal-Bereitstellungsverfahren mit Klangspektrumauswahl für ein Tonsignal mit den oberbegrifflichen Merkmalen des Patentanspruchs 8.

Allgemein bekannt ist die Möglichkeit, ein über Lautsprecher wiederzugebendes Tonsignal vor der Wiedergabe gemäß einem vorgegebenen Klangspektrum zu bearbeiten. Die Wahrnehmung von beispielsweise klassischer Musik mit einem hohen Dynamikbereich ist bei der Wiedergabe in einem fahrenden Kraftfahrzeug durch die Fahrgeräusche stark eingeschränkt. Damit die leisen Passagen der Musik wahrgenommen werden können, muss die Lautstärke erhöht werden. Hingegen müsste die Musik bei lauten Passagen leiser gestellt werden, um akustische Warnsignale aus der Fahrzeugumgebung wahrnehmen zu können. Um ein häufiges Verstellen der Lautstärke vermeiden zu können, wird üblicherweise ein Kompressor in Verbindung mit einem Limiter verwendet.

Beim Wechsel zwischen verschiedenen Programmarten ist es jedoch zweckmäßig, die Einstellungen des Kompressors und Limiters (Begrenzers) an die jeweilige Programmart anzupassen. Diese erforderliche Anpassung ist in einem Kraftfahrzeug mit einer verminderten Aufmerksamkeit für den Straßenverkehr verbunden und somit nachteilhaft. Besonders kritisch ist eine solche manuelle Einstellung nach der Auswahl eines anderen Programms dann, wenn nicht nur per einfachem Tastendruck auf eine Auswahl bereits abgespeicherter Klangspektren zurückgegriffen werden kann, sondern individuelle Klangspektrumsparameter einzeln eingestellt werden müssen.

Allgemein bekannt sind Rundfunkprogramme, bei welchen zusätzlich zu dem Tonsignal eine Programmtypkennung (PTY) ausgesendet wird. Die Programmtypkennung dient dazu, eine Unterscheidung zwischen beispielsweise Nachrichten- , Unterhaltungsmusik- oder Klassikmusiksendern vorzunehmen. Mit Hilfe dieser Kennung wird ein gezielter, nach Programmtypen getrennter Sendersuchlauf ermöglicht, so dass ein Fahrzeugführer ohne eine Vielzahl von begonnenen Suchläufen gezielt aus einer Anzahl von verfügbaren Sendern des gewünschten Programmtyps auswählen kann.

Allgemein bekannt ist auch ein Radio-Daten-System (RDS), mit welchem bei UKW-Sendern digitale Informationen übertragen werden. Anhand dieser digitalen Informationen werden dem Empfänger unter anderem der Name des Senders sowie dessen Sendefrequenz auf einer Anzeigeeinrichtung angezeigt. Das Radio-Daten-System ermöglicht beim Einsatz in Kraftfahrzeugen auch ein kontinuierliches automatisches Umschalten auf die jeweils empfangsgünstigste Sendefrequenz des gewählten Programms.

Allgemein bekannt ist auch ein Datenfunkkanal unter der Bezeichnung SWIFT / DARC (DAta Radio Channel) zur Übertragung von Zusatzinformationen über einen FM-Radiokanal. Mit einem geeigneten Terminal, einer Kombination aus FM-Radio und Datendecoder, können binäre Informationen, die mit einer Datenrate von 10k BIT/S über einen Radiosender verschickt werden, im Empfänger entschlüsselt werden. Dieses System wird zur Übertragung von z. B. ausführlichen Verkehrsberichten und Nachrichten in Japan eingesetzt, wo das Radio-Daten-System nicht verwendet wird.

Speziell für Autoradios ist das sogenannte Digital-Auto-Broadcasting als digitales und weitgehend störungsfreies Übertragungsverfahren für Rundfunk- und Datenanwendungen allgemein bekannt. Klanglich ist die Tonsignalwiedergabe gegenüber der herkömmlicher Radios deutlich besser. Das Angebot an Autoradios mit Anschlussmöglichkeit für entsprechende digitale Rundfunkempfänger wächst zunehmend.

Die DE 198 48 491 A1 offenbart ein Verfahren zur Beeinflussung einer Klangcharakteristik eines wiederzugebenden Audiosignals in einem Rundfunkempfänger. Bei dem Verfahren werden in einem Speicher abgelegte Klangcharakteristiken für wiederzugebende Audiosignale in Abhängigkeit einer über eine aktuell am Rundfunkempfänger eingestellte Rundfunksendefrequenz übertragenen Programmartkennung TTY einer Klangbeeinflussungseinrichtung zugewiesen. Dadurch wird eine automatische Anpassung der Klangcharakteristik eines wiederzugebenden Audiosignals an die Programmart des über die eingestellte Rundfunksendefrequenz übertragenen Empfangs ermöglicht.

Die EP 1 005 252 A1 offenbart ein Verfahren zur Beeinflussung der Klangcharakteristik eines wiederzugebenden Audiosignals. In einem Speicher sind verschiedene Audiosignalträger kennzeichnende Kennungen und den Audiosignalträgern bzw. den gespeicherten Kennungen zugeordnete Klangcharakteristiken gespeichert. Mittels einer steuerbaren Klangbeeinflussungseinrichtung werden die wiederzugebenden Audiosignale in Abhängigkeit der den Audiosignalträgern im Speicher zugewiesene benutzerdefinierten Klangcharakteristika beeinflusst. Somit ergibt sich die Möglichkeit, automatisch bei Auswahl eines wiederzugebenden Audiosignalträgers, diesen mit einer optimal an die Hörgewohnheiten des Benutzers angepassten Klangcharakteristik wiederzugeben.

Die US 5,983,191 offenbart ein Verfahren zum automatischen Kompensieren einer Klangfarbe. In einem ersten Schritt des Verfahrens wird bestimmt, ob ein Kanal geändert oder ein Audioeingangssignal geschaltet wurde. In einem zweiten Schritt wird ein Frequenzverlauf des Audioeingangssignals berechnet und das Ergebnis mit Daten einer Tabelle verglichen. In einem dritten Schritt wird das Eingangsaudiosignal als ein kleinster Fehlermodus während des zweiten Schritts bestimmt und schließlich wird in einem vierten Schritt eine Klangfarbe in Übereinstimmung mit dem bestimmten Modus kompensiert.

Die Aufgabe der Erfindung besteht darin, ein Verfahren bzw. eine Vorrichtung zur Tonsignalbearbeitung mit einem ausgewählten Klangspektrum zu verbessern, so dass insbesondere für Fahrzeugführer weniger Aufmerksamkeit für die geeignete Klangspektrumauswahl erforderlich ist.

Diese Aufgabe wird durch eine Tonsignal-Bearbeitungsvorrichtung zum Bereitstellen eines mit einem Klangspektrum bearbeiteten Tonsignals gemäß den Merkmalen des Patentanspruchs 1 bzw. ein Tonsignal-Bearbeitungsverfahren zum Bereitstellen eines mit einem Klangspektrum bearbeiteten Tonsignals gemäß den Merkmalen des Patentanspruchs 8 gelöst.

Ausgehend von einer Tonsignal-Bearbeitungsvorrichtung zum Bereitstellen eines mit einem Klangspektrum bearbeiteten Tonsignals, wobei das Klangspektrum mittels einer Klangauswahleinrichtung aus einer Vielzahl verschiedener Klangspektren ausgewählt wird, werden Zusatzinformationen ausgenutzt, welche dem Eingangs-Tonsignal zugeordnet sind. Diese Zusatzinformationen werden zusammen mit dem Eingangs-Tonsignal oder parallel zu diesem in einer Tonbereitstellungseinrichtung bereitgestellt. Vorteilhafterweise kann mit Hilfe der Klangauswahleinrichtung durch eine Kopplung der Zusatzinformation an ein bestimmtes Klangspektrum aus der Vielzahl von Klangspektren über eine automatische Zuordnung das bestgeeignete Klangspektrum ermittelt werden, so dass das Eingangstonsignal mit einem automatisch zugeordneten Klangspektrum bearbeitet wird. Besonders vorteilhaft ist der Einsatz einer solchen Tonsignal-Bearbeitungsvorrichtung bzw. eines entsprechenden Tonsignal-Bearbeitungsverfahrens in einer KFZ-Tonwiedergabeeinrichtung, da ein Fahrzeugführer lediglich das gewünschte Programm oder die bestimmte Musikquelle auswählen muss und die Zuordnung eines entsprechenden Klangspektrums keine weitere Aufmerksamkeit und somit Ablenkung gegenüber dem Straßenverkehr erforderlich macht.

Das Eingangs-Tonsignal stammt von einer Vielzahl verschiedenartigster Signalquellen. Dazu zählen neben einem üblichen Rundfunksignal insbesondere auch Kassetten-Wiedergabegeräte, CD/DVD-Wiedergabegeräte und an das System angeschlossene Mobilfunkgeräte. Möglich ist aber auch der Einsatz andersartiger Musikquellen, beispielsweise von Speichern, in denen zuvor ausgewählte Musikstücke abgespeichert wurden.

Eine Zusatzinformation ist die Information über einen bestimmten Signaleingang der Bearbeitungsvorrichtung, wenn mit diesem Signaleingang eine spezielle Tonsignalquelle, z. B. ein Mobilfunkgerät, verbunden ist.

Vorteilhafte Ausgestaltungen sind Gegenstand abhängiger Ansprüche.

Soweit als Tonsignal ein Signal mit Musikinformationen beschrieben wird, ist dies nur beispielhaft. Natürlich sind darunter auch Sprachsignale zu verstehen, die in entsprechender Art und Weise verarbeitet werden, beispielsweise Sprachsignale von reinen Nachrichtensendern oder von Mobilfunkgeräten.

Entsprechend der Vielfalt an verschiedenen möglichen Eingangs-Tonsignalquellen gibt es auch eine Vielfalt an verschiedenartigen Zusatzinformationen, welche zur Zuordnung eines Klangspektrums verwendet werden können. Diese Zusatzinformationen müssen dabei nicht zwingend eine Zusatzinformation sein, welche direkt mit dem Programmtyp oder einer Programmkennung verknüpft ist. Verwendet werden können als Zusatzinformation insbesondere eine Programmtypkennung (PTY), eine Programmkennung gemäß beispielsweise dem Radio-Daten-System (RDS), eine Zusatzinformation gemäß SWIFT / DARC (DAta Radio Channel), Zusatzinformationen des Digital-Auto-Broadcasting (DAB), aber auch reine Begleitinformationen, wie beispielsweise eine Textinformation auf einer DVD (Digital Versatile Disc) oder CD (Compact Disc). Neben diesen mehr oder weniger direkt mit dem Eingangs-Tonsignal verbundenen Zusatzinformationen können als Zusatzinformation auch durch die Tonsignal-Bearbeitungsvorrichtung selber gewonnene Zusatzinformationen verwendet werden. Dazu zählt beispielsweise ein Spracheingangssignal, welches von einem Mikrophon aufgenommen und mit einer Spracherkennungsverarbeitung ausgewertet wird.

Vorteilhaft ist auch die Analyse des Eingangs-Tonsignals mit Blick auf Dynamik- und Frequenzgehalt zur automatischen Bestimmung des Programmtyps. Sogar die Bestimmung von Nutz- und Störanteilen des Eingangs-Tonsignals zum Konstruieren eines individuell angepassten Klangspektrums ist vorteilhaft möglich.

Zweckmäßigerweise weist eine Tonsignal-Bearbeitungsvorrichtung einen Zusatzschalter für eine manuelle oder automatische Klangspektrumauswahl auf, so dass ein Fahrer wahlweise eine automatische Klangspektrumauswahl oder eine manuelle Klangspektrumauswahl vornehmen kann, falls die automatische Klangspektrumauswahl falsch sein sollte oder subjektive Umstände dies erforderlich machen. In einer Fahrtpause ist z. B. der volle Dynamikbereich ernster Musik wiedergebbar.

Die Klangspektrumauswahl wird vorteilhafterweise an den Empfängertyp gekoppelt, so dass für ein eingehendes Eingangs-Tonsignal eines digitalen Radio-Empfängers ein Klangspektrum für hochqualitative Musik oder Tonwiedergabe ausgewählt wird, während für ein empfangenes Analogsignal eine Klangspektrumauswahl für ein niederqualitativeres Eingangs-Tonsignal durchgeführt wird. Insbesondere kann für Mobilfunkgeräte als Signalquelle eines Eingangs-Toneingangssignals ein spezielles Klangspektrum bereitgestellt werden, welches nicht nur berücksichtigt, dass das empfangene Eingangs-Tonsignal Sprachinformationen umfasst, sondern auch berücksichtigt, dass derartige Eingangs-Tonsignale oftmals aufgrund von Übertragungsproblemen starkem Rauschen und sonstigen Störeinflüssen unterliegen.

Vorteilhafterweise werden in einem Speicher, in dem verschiedene Klangspektren hinterlegt sind, Zusatzinformationen zugeordnet, wie diese beispielhaft vorstehend aufgeführt sind. Neben der Bereitstellung von vorgegebenen Klangspektren werden zweckmäßigerweise auch frei programmierbare Klangspektren bereitgestellt, so dass ein Bediener individuell Klangspektren zu speziellen und von dem Bediener ausgewählten Zusatzinformationen einprogrammieren kann. Als Manipulationseinrichtung kann z. B. auch die zentrale Recheneinrichtung verwendet werden.

Ein Ausführungsbeispiel wird nachfolgend anhand der Zeichnung näher erläutert. Es zeigen:

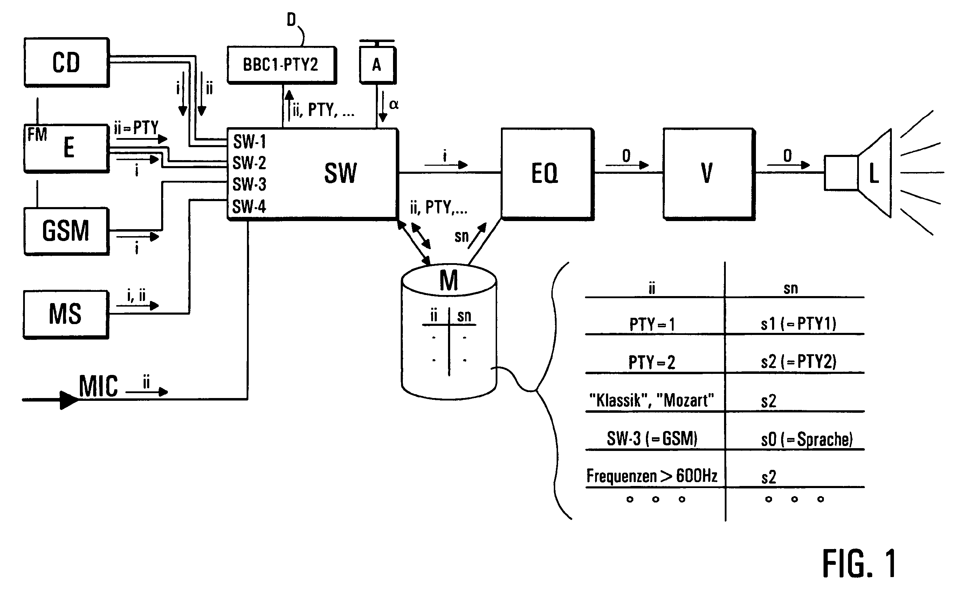

- Fig. 1: eine beispielhafte Schaltungsanordnung zum Bereitstellen eines mit einem ausgewählten Klangspektrum bearbeiteten Tonsignals und
- Fig. 2: ein Ablaufdiagramm für einen beispielhaften Verfahrensablauf zum Bereitstellen eines mit einem ausgewählten Klangspektrum bearbeiteten Tonsignals.

Eine Tonsignal-Bearbeitungsvorrichtung besteht üblicherweise aus einer Vielzahl von Einzelkomponenten und steht mit weiteren Komponenten in Verbindung. Nachfolgend werden nur die zum Verständnis der speziellen Anordnung und Funktionen erforderlichen Einrichtungen und Vefahrensschritte beschrieben. Eine Übertragung auf vergleichbare Einrichtungen ist möglich. Bei dem dargestellten bevorzugten Ausführungsbeispiel soll die Tonsignal-Bearbeitungsvorrichtung Bestandteil eines Kraftfahrzeugradios für den Betrieb in einem Kraftfahrzeug sein.

Die dargestellte Tonsignal-Bearbeitungsvorrichtung weist eine Tonsignal-Bearbeitungseinrichtung EQ auf, in welcher ein Eingangs-Tonsignal i entsprechend den Vorgaben eines Klangspektrums sn in für sich bekannter Art und Weise bearbeitet wird. Das derart mit dem Klangspektrum sn bearbeitete Tonsignal o wird üblicherweise an weitere Einrichtungen, beispielsweise einen Verstärker V und letztendlich einen Lautsprecher L, ausgegeben.

Das Eingangs-Tonsignal i stammt von einer Tonsignalquelle. Die Tonsignalquelle kann beispielsweise eine Empfängereinrichtung E zum Empfang eines Rundfunksignals sein. Eine andere mögliche Tonsignalquelle ist beispielsweise eine CD- oder DVD-Wiedereingabeeinrichtung CD. Eine andere beispielhaft dargestellte Tonsignalquelle ist ein Mobilfunkgerät GSM, welches ein empfangenes Signal, insbesondere Sprachsignal, als Eingangs-Tonsignal i ausgibt. Weitere beispielhafte Tonsignalquellen sind z. B. ein Mikrophon MIC, welches gesprochene Sprache, insbesondere Steueranweisungen, als Eingangs-Tonsignal i aufnimmt und weiterleitet. Eine noch weitere beispielhafte Tonsignalquelle kann auch ein Speicher MS sein, in dem durch den Bediener der Vorrichtung zuvor ausgewählte Musikstücke oder Sprachsignale als Eingangs-Tonsignal i abgespeichert wurden.

Diese Eingangs-Tonsignale i werden über entsprechende Verbindungen einer Klangauswahleinrichtung SW zugeführt und von dieser an die Tonsignal-Bearbeitungseinrichtung EQ weitergeleitet. Die Tonsignal-Bearbeitungseinrichtung EQ übernimmt beispielsweise Funktionen eines Equalizers. Bei de dargestellten Ausführungsform sind an die Klangauswahleinrichtung SW verschiedene Tonsignalquellen CD, E, GSM, MIC, MS angeschlossen.

Die Klangauswahleinrichtung steht mit einer Speichereinrichtung M in Verbindung, wobei in der Speichereinrichtung M zwei oder eine Vielzahl m mit n 2, ..., n, ... , m-1 verschiedenen Klangspektren sn abgespeichert sind. Die verschiedenen Klangspektren sn können fest vorgegebene Klangspektren sein, möglich ist aber auch die Änderung der einzelnen Parameter der Klangspektren sn durch einen Bediener oder auch die Neueingabe und/oder zusätzliche Eingabe weiterer Klangspektren sn je nach Ausgestaltung der Tonsignal-Bearbeitungsvorrichtung.

Die Klangauswahleinrichtung SW wählt zu dem jeweils zur Weiterleitung empfangenen Eingangs-Tonsignal i ein geeignetes, insbesondere das bestgeeignete Klangspektrum für dieses Eingangs-Tonsignal i aus der Vielzahl verschiedener Klangspektren sn aus. Durch Anweisung der Speichereinrichtung mittels eines Auswahlsignals, insbesondere einer Zusatzinformation ii, welche in dem Speicher M einem der verschiedenen Klangspektren sn eindeutig zugeordnet ist, wird der Speicher M veranlasst, das zugeordnete Klangspektrum sn an die Tonsignal-Bearbeitungseinrichtung EQ auszugeben. Diese verarbeitet daraufhin das Eingangs-Tonsignal i mit dem ausgewählten Klangspektrum sn.

Zur Steuerung der einzelnen Abläufe dient insbesondere eine zentrale Steuereinrichtung C, welche mit den einzelnen Einrichtungskomponenten verbunden ist. Möglich sind aber auch Ausführungsformen mit baulich voneinander unabhängig gesteuerten Einrichtungskomponenten oder auch Ausführungsformen, bei welchen alle oder die meisten Einrichtungskomponenten in einem einzigen integrierten Schaltkreis aufgenommen sind.

Damit die Klangauswahleinrichtung SW ein Kriterium zum Auswählen des geeigneten Klangspektrums sn aus der Vielzahl m der verschiedenen Klangspektren sn erhält, wird eine Zusatzinformation ii in der Klangauswahleinrichtung SW verarbeitet.

Im Fall einer Empfängereinrichtung E zum Empfang eines Rundfunksignals kann die Zusatzinformation ii aus einem zusätzlich übertragenen Signal bestehen, welches für das Rundfunkprogramm und/oder den Typ des Rundfunkprogramms ausreichend eindeutig zugeordnet ist.

Beispielsweise kann die Zusatzinformation ii eine Programmtypkennung PTY sein, welche in für sich bekannter Art und Weise zusammen mit dem Eingangs-Tonsignal i oder parallel zu diesem von einem Rundfunksender ausgesendet und in der Empfängereinrichtung E empfangen wird. Anhand der Analyse der Programmtypkennung PTY kann die Klangauswahleinrichtung SW beispielsweise zwischen einem Rundfunkprogramm unterscheiden, welches Nachrichten, Unterhaltungsmusik oder ernste Musik überträgt. Dementsprechend wählt die Klangauswahleinrichtung SW dann ein Klangspektrum sn = s0, s1 oder s2 aus, wobei diese Klangspektren s0, s1, s2 entsprechend an die Wiedergabe von Nachrichten, Unterhaltungsmusik oder ernste Musik angepasst sind. In der Tonsignal-Bearbeitungseinrichtung EQ wird somit das empfangene Eingangs-Tonsignal i für die Wiedergabe von Nachrichten, Unterhaltungsmusik oder ernste Musik optimiert und derart bearbeitet als Tonausgangssignal o ausgegeben.

Anstelle oder zusätzlich zu der Bestimmung einer Programmtypkennung PTY als Zusatzinformation ii kann als Zusatzinformation ii beispielsweise auch eine zusätzliche Information gemäß dem für sich bekannten Radio-Daten-System RDS verwendet werden. In diesem Fall würden in dem Speicher M Zuordnungen der einzelnen Klangspektren sn zu Teilen der digitalen Informationen zugeordnet, welche mittels des Radio-Daten-Systems RDS übertragen werden. Beispielsweise kann als Zusatzinformation ii der Name eines bestimmten Senders und/oder dessen Sendefrequenz in dem Speicher M abgespeichert sein. In diesem Fall ist eine Bearbeitungsmöglichkeit, insbesondere Ergänzungsmöglichkeit durch den Bediener der Tonsignal-Bearbeitungsvorrichtung, d. h. insbesondere den Fahrzeugführer, zweckmäßig, so dass dieser einem ausgewählten Klangspektrum auch nachträglich bestimmte Sender und/oder Frequenzen zuordnen kann.

Zusätzlich oder alternativ können mit dem Radio-Daten-System RDS aber auch direkt Zusatzinformationen ii übertragen werden, welche durch die Klangauswahleinrichtung SW direkt verarbeitet werden können.

Für Rundfunkgeräte als Empfängereinrichtung E sind beispielsweise auch Informationen als Zusatzsignal ii verwertbar, welche über einen FM-Radiokanal gemäß den Vorgaben der Rundfunksysteme SWIFT oder DARC übertragen werden.

Noch ein weiteres beispielhaftes Rundfunksystem ist das Digital-Auto-Broadcasting DAB, mit welchem ebenfalls geeignete Zusatzinformationen ii übertragen und durch die Empfängereinrichtung E empfangen werden können.

Sofern die Empfängereinrichtung E die Aufschlüsselung des empfangenen Funksignals in ein Eingangs-Tonsignal i und in eine getrennte Zusatzinformation ii nicht vornimmt, kann dies auch durch eine entsprechende Einrichtungskomponente in der Klangauswahleinrichtung SW durchgeführt werden.

Möglich ist auch die Zwischenschaltung einer weiteren Einrichtung, welche ein empfangenes Signal in ein Eingangs-Tonsignal i und in ein Signal mit einer Zusatzinformation ii aufsplittet und der Klangauswahleinrichtung zuführt. Für den Fall, dass bereits eingangsseitig ein getrenntes Eingangs-Tonsignal i und eine davon getrennte Zusatzinformation ii bereitgestellt werden, kann das Eingangs-Tonsignal i auch unter Umgehung der Klangauswahleinrichtung SW direkt zu der Tonsignal-Bearbeitungseinrichtung EQ geleitet werden, während die separate Zusatzinformation ii der Klangauswahleinrichtung SW zum Auswählen des geeigneten Klangspektrums sn zugeführt wird.

Wie aufgeführt, werden der Klangauswahleinrichtung SW auf diese oder eine dazu modifizierte Art und Weise auch Signale anderer Signalquellen zugeführt werden. Insbesondere bei einem Kraftfahrzeugradio gibt es eine Vielzahl verschiedenartiger Tonsignalquellen, welche zweckmäßigerweise mit der Klangauswahleinrichtung SW verbunden werden, welche dann für das jeweils auszugebende Tonausgangssignal o das geeignete Klangspektrum sn auswählt.

Im Fall der CD- oder DVD-Wiedergabeeinrichtung kann als Zusatzinformation ii beispielsweise eine Textinformation verwendet werden, welche zusätzlich zu dem eigentlichen Tonsignal i auf dem Datenträger abgespeichert ist. Die Zusatzinformation ii kann wiederum eine spezielle Zusatzinformation ii zur Auswahl eines Klangspektrums sein, kann aber auch eine beliebige andere Zusatzinformation ii sein, sofern für die Klangauswahleinrichtung SW eine entsprechende Zuordnung zu dem geeigneten Klangspektrum möglich ist, z. B. durch entsprechende Programmierung einer Zuordnungstabelle.

Prinzipiell möglich ist auch die Auswahl eines geeigneten Klangspektrums sn zu einem Eingangs-Tonsignal i, welches von einer Tonsignalquelle stammt, der von Hause aus keine Zusatzinformation ii beigefügt ist, wie dies bei den vorstehend beschriebenen Fällen gegeben ist.

Eine solche Tonsignalquelle ist z. B. das dargestellte Mobilfunkgerät GSM. Mit diesem werden insbesondere Sprachdaten als Eingangs-Tonsignal i zu der Klangauswahleinrichtung SW und/oder der Tonsignal-Bearbeitungseinrichtung EQ geführt. Da es sich vorzugsweise um Sprachsignale als Eingangs-Tonsignal i handeln wird, kann ein diesbezüglich optimiertes Klangspektrum sn in dem Speicher M abgespeichert werden, welches nicht nur Sprache als Tonsignal berücksichtigt sondern auch eine besonders schlechte, verrauschte und durch Funkverbindungsstörungen gestörte Tonsignalqualität berücksichtigt. Als Kriterium für die Klangauswahleinrichtung SW kann in diesem Fall z. B. der verwendete Eingangskanal SW-3 verwendet werden. Dies bedeutet, dass immer dann das spezielle Klangspektrum sn zur Wiedergabe von dem Mobilfunk-Tonsignal i verwendet wird, wenn der Tonsignal-Bearbeitungseinrichtung EQ das Eingangs-Tonsignal von der Leitung bzw. dem Eingang SW-3 zugeführt wird, an dem das Mobilfunkgerät GSM angeschlossen ist.

Möglich ist als weitere zusätzliche Auswahlfunktion zum Auswählen des geeigneten Klangspektrums sn auch eine direkte Analyse des in die Klangauswahleinrichtung SW eingeführten Eingangs-Tonsignals i. Beispielsweise können der Frequenzgang und/oder der dynamische Verlauf des Eingangs-Tonsignals i in der Klangauswahleinrichtung SW analysiert werden. Im Falle von ernster Musik kann als Unterscheidungskriterium beispielsweise ein sehr großes Frequenzspektrum mit stark variierenden dynamischen Intensitäten zugeordnet werden. Für Unterhaltungsmusik kann als Kriterium das Vorkommen von gleichmäßig rhythmischen und/oder weniger stark variierenden Frequenz- und Dynamikwerten dienen. Sprachsignale und Nachrichtensender können beispielsweise anhand der typischen sehr beschränkten Frequenzgehalte des Eingangs-Tonsignals i bestimmt und erkannt werden.

Die Klangauswahleinrichtung SW weist vorteilhafterweise eine Anzeigeeinrichtung D auf, welcher die Zusatzinformation ii oder eine entsprechend aufbereitete Information zur Anzeige für den Bediener, insbesondere Kraftfahrzeugführer, zugeführt wird. Im Falle der Verwendung des PTY- oder RDS-Codes können direkt die entsprechenden und für sich bekannten Anzeigen bereitgestellt werden. Möglich ist aber auch eine spezielle Aufbereitung und direkte Anzeige des ausgewählten Klangspektrums.

Vorteilhafterweise weist die Klangauswahleinrichtung SW auch eine Möglichkeit zum Ausschalten der automatischen Auswahl des geeigneten Klangspektrums sn auf. Dies kann beispielsweise ein einfacher Tastschalter A sein, von dem ein Ein- oder Aus-Signal a zur Klangauswahleinrichtung SW oder einer zentralen Steuereinrichtung C geführt wird. Je nach Zustand dieses Signals a kann der Bediener die automatische Klangauswahl ein- oder ausschalten. Im Fall der ausgeschalteten automatischen Klangauswahl kann der Bediener vorzugsweise auch selber direkt eines der verfügbaren der verschiedenen Klangspektren sn auswählen. Möglich ist auch eine gänzlich manuelle Einstellung durch den Bediener, welche von einem Basis-Klangspektrum ausgeht, nachdem die automatische Klangspektrumsauswahl abgeschaltet ist.

Neben einem solchen Schalter A können auch andere Eingabemöglichkeiten für den Bediener bereitgestellt werden, um die Klangauswahl zu beeinflussen. Beispielsweise kann ein Mikrophon MIC, insbesondere ein für Mobilfunk bereitgestelltes Mikrophon MIC, verwendet werden, um Sprachbefehle als Zusatzinformation ii einzugeben. In diesem Fall werden solche Sprachbefehle ii von der Klangauswahleinrichtung SW oder einer anderen Einrichtungskomponente, z. B. der zentralen Steuereinrichtung C, analysiert und entsprechend verarbeitet.

Damit ein Hörer bzw. Bediener nach einem Wechsel der Programmart nicht ständig auch die Auswahl des Klangspektrums ändern muss, ermöglicht eine solche Schaltungsanordnung somit eine automatische Auswahl des geeigneten Klangspektrums. Für die Erkennung des Programmtyps eines Rundfunksignals wird beispielsweise eine Programmtypkennung verwendet, die vom Programmanbieter zur Verfügung gestellt wird. Bei FM-Betrieb kann dies beispielsweise das für sich bekannte RDS sein, in welchem der sogenannte PTY-Code enthalten ist. Somit kann ein Rundfunkempfänger nach der Auswertung des RDS-Signals den Programmtyp zur Verfügung stellen, anhand dessen zusätzlich auch die Klangeinstellung durch Auswahl des geeigneten Klangspektrums durchgeführt wird.

Geeignet ist eine solche Verfahrensweise aber auch beim Wechsel auf eine Sendung mit vorwiegender Sprachwiedergabe, um den Klang entsprechend zu optimieren, so dass das Frequenzband der Sprache hervorgehoben wird. In besonders bevorzugter Ausführungsform kann auch eine automatische Bestimmung eines speziell geeigneten Klangspektrums durchgeführt werden, bei dem ein bestimmtes Frequenzband, welches sich von einem ermittelten Hintergrundrauschen abhebt, besonders hervorgehoben wird.

Möglich ist auch die Verwendung einer Programmtypkennung, die auf einem andersartigen Tonträger abgespeichert wird und eigentlich einem anderen oder auch diesem Zweck der Klangspektrumsauswahl dient.

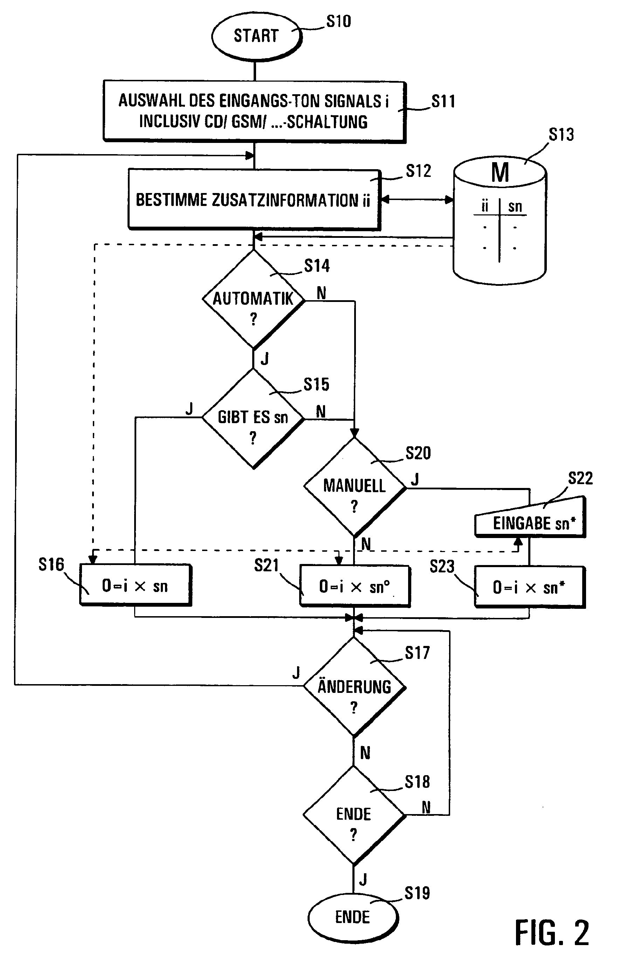

Anhand Fig. 2 ist ein beispielhafter Verfahrensablauf zum Betrieb einer solchen Klangauswahleinrichtung SW veranschaulicht. Nach dem Start (S10) der Vorrichtung findet eine Auswahl eines Eingangs-Tonsignals i statt (S11). Dies kann sowohl die Auswahl eines anderen Rundfunksenders einer Rundfunk-Empfängereinrichtung E sein, kann aber auch die Auswahl einer anderen Tonsignalquelle, beispielsweise die Auswahl der CD-Wiedereingabeeinrichtung CD anstelle der Rundfunk-Empfängereinrichtung E sein. Eine automatische Auswahl des Eingangs-Tonsignals i kann von dem System beispielsweise dann durchgeführt werden, wenn Verkehrsnachrichten über die Rundfunk-Empfängereinrichtung E oder ein Anruf über das Mobilfunkgerät GSM eingehen und bevorzugt durch den Lautsprecher L ausgegeben werden sollen.

Nach der Bestimmung bzw. Auswahl des Eingangs-Tonsignals i wird die bestgeeignete oder bereits direkt zuordbare Zusatzinformation ii bestimmt (S12). Nachfolgend wird das entsprechende Klangspektrum sn ausgewählt und zur Verarbeitung der Tonsignal-Bearbeitungseinrichtung EQ zugeführt (S13). In bevorzugter Ausführungsform findet fortwährend eine Bestimmung statt, ob die automatische Auswahl des Klangspektrums eingeschaltet ist (S14). Falls ja, wird nachfolgend bestimmt, ob ein für das Eingangs-Tonsignal i geeignetes Klangspektrum sn überhaupt vorliegt (S15). Falls ja, wird das Tonausgangssignal o aus dem Eingangs-Tonsignal i und dem ausgewählten Klangspektrum sn erzeugt und über weitere Komponenten, insbesondere einen Lautsprecher L, ausgegeben (S16).

Abschließend wird forwährend bestimmt, ob das Eingangs-Tonsignal i , insbesondere das wiedergegebene Rundfunkprogramm oder die Tonsignalquelle, verändert wurde (S17). Falls ja, wird zu dem Schritt der Bestimmung der Zusatzinformation ii zurückgeschritten (S12). Falls nein, wird in einer weiteren Schleife (S18) überprüft, ob eine weitere Wiedergabe eines Eingangs-Tonsignals i durchgeführt wird, d. h. z. B., ob das Kraftfahrzeugradio noch eingeschaltet ist oder der Verfahrensablauf beendet werden soll (S19).

Falls bei der Überprüfung, ob die automatische Auswahl des Klangspektrums (S14) eingeschaltet ist, festgestellt wird, dass die automatische Auswahl des Klangspektrums sn nicht gewünscht ist, wird die Zusatzinformation ii je nach Auswahl (S20) ignoriert und das Tonausgangssignal o aus dem Eingangs-Tonsignal i mit einem Standardklangspektrum sn° (S21) oder einem durch den Bediener manuell eingegebenen oder veränderten (S22) Klangspektrum sn* erzeugt. Selbiges gilt auch für den Fall, dass bei eingeschalteter automatischer Auswahl des geeigneten Klangspektrums sn festgestellt wird, dass kein geeignetes Klangspektrum verfügbar ist oder keine geeignete Zusatzinformation ii bereitsteht (S15). Auch in diesem Fall wird eine Erzeugung des Tonausgangssignals o mit einem Standardklangspektrum sn° oder einem manuell eingestellten Klangspektrum sn* bewirkt.

## Patentansprüche

1. Tonsignal-Bearbeitungsvorrichtung, insbesondere Kraftfahrzeug-Radio, mit
- einer Tonsignal-Bearbeitungseinrichtung (EQ) zum Bearbeiten eines Eingangs-Tonsignals (i) mit einem Klangspektrum (sn) zum Ausgeben eines mit dem Klangspektrum (sn) bearbeiteten Tonausgangssignals (o),
- einer Klangauswahleinrichtung (SW) zum Auswählen des Klangspektrums (sn) aus zwei oder einer Vielzahl (m) verschiedener Klangspektren (sn, n = 0, 1, 2, ..., n, ... m),
- wobei dem Eingangs-Tonsignal (i) eine Zusatzinformation (ii) zugeordnet ist und die Zusatzinformation (ii) mit oder parallel zu dem Eingangs-Tonsignal (i) in der Tonsignal-Bearbeitungsvorrichtung bereitsteht,
- wobei die Klangauswahleinrichtung (SW) ausgebildet ist, das Klangspektrum (sn) abhängig von der dem Tonsignal (i) zugeordneten Zusatzinformation (ii) automatisch auszuwählen, mit zumindest einer Tonsignalquelle zum Bereitstellen des Eingangs-Tonsignals (i), insbesondere mit einem Tonsignalspeicher (MS), einer Rundfunk-Empfängereinrichtung (E), einer CD- oder DVD-Wiedergabeeinrichtung (CD) und/oder einem Mobilfunkgerät (GSM) als Signalquelle für das Eingangs-Tonsignal (i),
**dadurch gekennzeichnet, dass**
die Klangauswahleinrichtung (SW) zum Auswählen des Klangspektrums (sn) anhand eines bestimmten Eingangs (SW-3) einer Vielzahl von Eingängen (SW-1, SW-2, SW-3) ausgebildet ist, über die verschiedene Eingangs-Tonsignale (i) von verschiedenen Tonsignalquellen (CD, E, GSM, MS) zugeführt werden.

2. Tonsignal-Bearbeitungsvorrichtung nach Anspruch 1, bei der die Klangauswahleinrichtung (SW) zum Auswählen des Klangspektrums (sn) anhand einer Programmkennung (RDS; SWIFT; DARC; DAB) und/oder einer Programmtypkennung (PTY) ausgebildet ist, wobei die Programmkennung und/oder die Programmtypkennung als Zusatzinformation (ii) unabhängig von dem Eingangs-Tonsignal (i) von der Tonsignalquelle (E) übertragen wird.

3. Tonsignal-Bearbeitungsvorrichtung nach Anspruch 1 oder 2, bei der die Klangauswahleinrichtung (SW) ausgebildet ist, die Auswahl des Klangspektrums (sn) anhand einer Textinformation oder Zusatzinformation (ii) durchzuführen, welche von der eigentlichen Datensignalquelle (CD; E) unabhängig von dem Eingangs-Tonsignal (i) übertragen wird.

4. Tonsignal-Bearbeitungsvorrichtung nach einem vorstehenden Anspruch, bei der die Klangauswahleinrichtung (SW) zum Auswählen des Klangspektrums (sn) mittels einer Tonanalyse des Eingangs-Tonsignals (i) ausgebildet ist, insbesondere mittels einer Frequenz- und/oder Dynamikanalyse.

5. Tonsignal-Bearbeitungsvorrichtung nach einem vorstehenden Anspruch mit einer Schalteinrichtung (A; MIC) zum Ein- oder Ausschalten der automatischen Auswahl des Klangspektrums (sn).

6. Tonsignal-Bearbeitungsvorrichtung nach einem vorstehenden Anspruch mit einem Speicher (M), in dem die zwei oder die Vielzahl verschiedener Klangspektren (sn) entsprechenden verarbeitbaren Zusatzinformationen (ii) zugeordnet sind.

7. Tonsignal-Bearbeitungsvorrichtung nach einem vorstehenden Anspruch mit einer Manipulationseinrichtung zum Ändern und/oder Hinzufügen der verschiedenen Klangspektren (sn).

8. Verfahren zum Bereitstellen eines Tonausgangssignals (o) aus einem Eingangs-Tonsignal (i) und einem diesem zugeordneten Klangspektrum (sn) aus zwei oder einer Vielzahl verschiedener Klangspektren, wobei dem Eingangs-Tonsignal (i) zumindest eine Zusatzinformation (ii) zugeordnet ist, wobei das Klangspektrum (sn) zum Bearbeiten des Eingangs-Tonsignals
(i) automatisch anhand der Zusatzinformation (ii) ausgewählt wird, wobei die Zusatzinformation (ii) mit dem Programmtyp verknüpft ist oder wird,
**dadurch gekennzeichnet, dass**
als Zusatzinformation (ii) die Information über den Typ der Datensignalquelle (GSM) verwendet wird, von der das Eingangs-Tonsignal (i) ausgegeben wird.

9. Verfahren nach Anspruch 8, bei dem als Zusatzinformation (ii) eine zusammen mit dem Eingangs-Tonsignal (i) übertragene Programmtypkennung (PTY) und/oder Senderkennung (RDS) übertragen wird.

10. Verfahren nach Anspruch 8, bei dem die Zusatzinformation (ii) eine von einer Tonsignalquelle (CD, E) unabhängige Zusatzinformation, insbesondere Textinformation ist, welche von einer Klangauswahleinrichtung analysiert wird.

11. Verfahren nach Anspruch 8, bei dem die Zusatzinformation (ii) durch Tonanalyse des Eingangs-Tonsignals (i), insbesondere Frequenz- und/oder Dynamikanalyse des Eingangs-Tonsignals (i), gewonnen wird.

## Claims

1. Sound signal processing device, in particular a motor vehicle radio, with
- a sound signal processing device (EQ) for the processing of an input sound signal (i) with a sound spectrum (sn) for the output of a sound output signal (o) processed with the sound spectrum (sn),
- a sound selection device (SW) for selecting the sound spectrum (sn) from two or a plurality (m) of different sound spectra (sn, n = 0, 1, 2, ..., n, ...., m),
- wherein a supplementary item of information (ii) is allocated to the input sound signal (i) and the supplementary item of information (ii) is provided with or in parallel to the input sound signal (i) in the sound signal processing device,
- wherein the sound selection device (SW) is designed to select the sound spectrum (sn) automatically, depending on the supplementary item of information (ii) allocated to the sound signal (i), with at least one sound signal source for the provision of the input sound signal (i), in particular with a sound signal storage memory (MS), a radio receiver device (E), a CD or DVD reproduction device (CD) and/or a mobile radio device (GSM) as a signal source for the input sound signal (i), **characterised in that** the sound selection device (SW) for selecting the sound spectrum (sn) is designed on the basis of a specific input (SW-3) of a plurality of inputs (SW-1. SW-2, SW-3), by means of which different input sound signals (i) are conducted from different sound signal sources (CD, E, GSM, MS).

2. Sound signal processing device according to Claim 1, in which the sound selection device (SW) is designed for the selection of the sound spectrum (sn) on the basis of a program identifier (RDS; SWIFT; DARC; DAB) and/or a program type identifier (PTY), wherein the program identifier and/or the program type identifier is transferred as a supplementary item of information (ii) independently of the input sound signal (i) from the sound signal source (E).

3. Sound signal processing device according to Claim 1 or 2, in which the sound selection device (SW) is designed to carry out the selection of the sound spectrum (sn) on the basis of an item of text information or a supplementary item of information (ii), which is transferred from the actual data signal source (CD; E) independently of the input sound signal (i).

4. Sound signal processing device according to a preceding claim, in which the sound selection device (SW) is designed to select the sound spectrum (sn) by means of a sound analysis of the input sound signal (i), in particular by means of a frequency and/or dynamic analysis.

5. Sound signal processing device according to a preceding claim, with a switch device (A; MIC) for switching the automatic selection of the sound spectrum (sn) on or off.

6. Sound signal processing device according to a preceding claim, with a memory (M), in which the two or the plurality of different sound spectra (sn) are allocated to corresponding, processable supplementary items of information (ii).

7. Sound signal processing device according to a preceding claim, with a manipulation device for changing and/or adding the different sound spectra (sn).

8. Method for the provision of a sound output signal (o) from an input sound signal (i) and a sound spectrum (sn) allocated to this from two or a plurality of different sound spectra, wherein at least one supplementary item of information (ii) is allocated to the input sound signal (i), wherein the sound spectrum (sn) for processing the input sound signal (i) is selected automatically on the basis of the supplementary information (ii), wherein the supplementary information (ii) is or will be linked to the program type,
**characterised in that**
as supplementary information (ii), the information about the type of the data signal source (GSM) is used, from which the input sound signal (i) is issued.

9. Method according to Claim 8, in which, as supplementary information (ii), a program type identifier (PTY) and/or transmitter identifier (RDS) is transferred together with the input sound signal (i).

10. Method according to Claim 8, in which the supplementary item of information (ii) is a supplementary item of information independent of a sound signal source (CD, E), in particular text information, which is analysed by a sound selection device.

11. Method according to Claim 8, in which the supplementary information (ii) is obtained by sound analysis of the input sound signal (i), in particular frequency and/or dynamic analysis of the input sound signal (i).

## Revendications

1. Dispositif de traitement de signal sonore, en particulier un autoradio, comprenant
- un moyen de traitement de signal sonore (EQ) pour traiter un signal sonore d'entrée (i) par un spectre sonore (sn) en vue d'émettre un signal sonore de sortie (o) traité par le spectre sonore,
- un moyen de sélection de sonorité (SW) pour sélectionner le spectre sonore (sn) parmi deux ou une pluralité (m) de spectres sonores différents (sn, n = 0, 1, 2, ..., n, ... m),
- une information supplémentaire (ii) étant associée au signal sonore d'entrée (i) et ladite information supplémentaire (ii) étant disponible dans le dispositif de traitement de signal sonore conjointement avec ou parallèlement au signal sonore d'entrée (i),
- le moyen de sélection de sonorité (SW) étant configuré pour sélectionner automatiquement le spectre sonore (sn) en fonction de l'information supplémentaire (ii) associée au signal sonore (i), avec au moins une source de signal sonore pour la mise à disposition du signal sonore d'entrée (i), en particulier avec une mémoire de signal sonore (MS), un moyen récepteur de radiodiffusion (E), un moyen de reproduction de CD ou de DVD et/ou un appareil radiotéléphonique mobile (GSM) à titre de source de signal pour le signal sonore d'entrée (i),
**caractérisé en ce que**
le moyen de sélection de sonorité (SW) pour sélectionner le spectre sonore (sn) est configuré à l'aide d'une entrée déterminée (SW-3) parmi une pluralité d'entrées (SW-1, SW-2, SW-3) par lesquelles des signaux sonores d'entrée (i) différents sont alimentés en provenance de différentes sources de signal sonore (CD, E, GSM, MS).

2. Dispositif de traitement de signal sonore selon la revendication 1, dans lequel le moyen de sélection de sonorité (SW) pour sélectionner le spectre sonore (sn) est configuré à l'aide d'une identification de programme (RDS; SWIFT; DARC; DAB) et/ou d'une identification de type de programme (PTY), l'identification de programme et/ou l'identification de type de programme étant transmise par la source de signal sonore (E) en tant qu'information supplémentaire (ii) indépendamment du signal sonore d'entrée (i) .

3. Dispositif de traitement de signal sonore selon la revendication 1 ou 2, dans lequel le moyen de sélection de sonorité (SW) est configuré pour effectuer la sélection du spectre sonore (sn) à l'aide d'une information textuelle ou information supplémentaire (ii) qui est transmise par la source de signal de données (CD; E) proprement dite indépendamment du signal sonore d'entrée (i).

4. Dispositif de traitement de signal sonore selon une revendication précédente, dans lequel le moyen de sélection de sonorité (SW) pour sélectionner le spectre sonore (sn) est configuré à l'aide d'une analyse de son du signal sonore d'entrée (i), en particulier à l'aide d'une analyse de fréquence et/ou de dynamique.

5. Dispositif de traitement de signal sonore selon une revendication précédente, comprenant un moyen de commutation (A; MIC) pour enclencher ou déclencher la sélection automatique du spectre sonore (sn).

6. Dispositif de traitement de signal sonore selon une revendication précédente, comprenant une mémoire (M) dans laquelle les deux ou la pluralité de spectres sonores différents (sn) sont associés à des informations supplémentaires (ii) correspondantes aptes à être traitées.

7. Dispositif de traitement de signal sonore selon une revendication précédente, comprenant un moyen de manipulation pour modifier et/ou ajouter les différents spectres sonores (sn).

8. Procédé de mise à disposition d'un signal sonore de sortie (o) à partir d'un signal sonore d'entrée (i) et d'un spectre sonore (sn) associé à ce dernier parmi deux ou une pluralité de spectres sonores différents, au moins une information supplémentaire (ii) étant associée au signal sonore d'entrée (i), le spectre sonore (sn) pour traiter le signal sonore d'entrée (i) étant automatiquement sélectionné à l'aide de l'information supplémentaire (ii), l'information supplémentaire (ii) étant liée au type de programme,
**caractérisé en ce que**,
en tant qu'information supplémentaire (ii), on utilise l'information sur le type de la source de signal de données (GSM) à partir de laquelle le signal sonore d'entrée (i) est émis.

9. Procédé selon la revendication 8, dans lequel, en tant qu'information supplémentaire (ii), on transmet une identification de type de programme (PTY) et/ou une identification d'émetteur (RDS) transmise avec le signal sonore d'entrée (i).

10. Procédé selon la revendication 8, dans lequel l'information supplémentaire (ii) est une information supplémentaire indépendante d'une source de signal sonore (CD, E), en particulier une information textuelle, qui est analysée par un moyen de sélection de sonorité.

11. Procédé selon la revendication 8, dans lequel l'information supplémentaire (ii) est obtenue par analyse de son du signal sonore d'entrée (i), en particulier par analyse de fréquence et/ou de dynamique du signal sonore d'entrée (i).
